# EUROPEAN PATENT APPLICATION

(11) **EP 4 621 420 A1**
(43) Date of publication of application: **24.09.2025**
(21) Application number: 24165155.3
(22) Date of filing: 21.03.2024
(51) Int. Cl.: G01R 29/08

(54) **SPATIAL POSITIONING DEVICE AND MOBILE SENSOR SYSTEM**

(71) Applicant: Evosoft Hungary Szamitastechnikai Kft., 1111 Budapest (HU)
(72) Inventor: Gál, Dávid, 1126 Budapest (HU); Juhász, István, 5700 Gyula (HU); Molnár, Attila5, 1144 Budapest (HU); Tóth, Péter7, 1202 Budapest (DE); Vari, Laszlo, 1117 Budapest (HU)
(74) Representative: Siemens Patent Attorneys

(57) **Abstract**

Spatial positioning device, comprising a sensor mounting platform (S) to mount a sensor means, a lifting means (L) to lift the sensor means vertically, a transport means (T) to move the lifting means (L) horizontally, wherein the lifting means (L) is arranged between the sensor mounting platform (S) and the transport means (T), and the transport means (T) comprises at least two wheels with respective axles, which wheels having an individual suspension means, and which axles are arranged in one plane, and the sensor mounting platform, the lifting means (L) and the transport means (T) are mainly made of an electrically non-conductive material.

## Description

The invention relates to a spatial positioning device and a mobile sensor system.

Several measurement applications require a sensor to be moved by a spatial positioning device to capture all spatial emissions, for instance for measuring electromagnetic emissions of a device under test.

However, it is important to use a positioning device which does not interfere with the emissions of the device under test, which would otherwise negatively influence the emissions.

Moreover, it is important to provide a high accuracy in the spatial positioning to enable accurate measurement results captured by a sensor.

In prior art, especially at big devices under test, for instance devices with more than one meter side length like a energy transformer, such measurements usually are done by hand with a handheld device, tape measure and a ladder near to a transformer under load.

However, manual measurement entails health risks, quite long procedure, and are neither precise nor repeatable.

It is the objective if the invention to provide a spatial positioning device with low interference to a device under test and with a high positioning accuracy.

The objective is solved by a spatial positioning device, comprising:
- A sensor mounting platform to mount a sensor means,
- A lifting means to lift the sensor means vertically,
- A transport means to move the lifting means horizontally,

wherein the lifting means is arranged between the sensor mounting platform and the transport means,
and the transport means comprises at least two wheels with respective axles, which wheels having an individual suspension means, and which axles are arranged in one plane,
and the sensor mounting platform, the lifting means and the transport means are mainly made of an electrically non-conductive material.

Thus, a device is provided for performing measurements for big devices under test with an enhanced accuracy and flexibility.

Virtually, common axles of wheel pairs can be thought through a respective pair of wheels arranged on opposite sides of the positioning device.

However, the wheels are driven individually to obtain a high maneuverability of the positioning device.

Consequently, the positioning device can reposition to a subsequent measurement position itself very quickly, since vibrations or oscillations stimulated by the movement can be stabilized quickly by the several suspensions means.

Further, impacts of disturbing ground bumps during movement of the positioning device can be reduced in an effective way.

Thus, fast measurement campaigns can be performed, with repeatable and high accuracy due to a high precision positioning of a sensor.

In a further development of the invention, the spatial positioning device according to the preceding claim, wherein sensor mounting platform, the lifting means and the transport means are made of an electrically non-conductive material by at least of 90%, preferably at least of 95% of the volume of the spatial positioning device.

As an alternative to said volume of the device, also the weight of the device can be used as a reference for the proportion of the electrically non-conductive material.

Thus, electromagnetic emission measurement of a device under test can be performed with reduced interference on the emissions of the device under test, e.g. an electric transformer, itself.

In a further development of the invention, the material of the lifting means contains glass fiber composite.

Thus, a high elevation of the sensor by the extended lifting means can be obtained due to a stable and lightweight construction of the lifting device.

In a further development of the invention, the lifting means is a cascade actuator, preferably including telescopic rails made of glass fiber composite and at least one lifting belt made of rubber or polyurethane, comprising aramid tensile cords or glass fiber tensile cords, which is configured to move the telescopic rails.

Thus, a high elevation of the sensor by the extended lifting means can be obtained due to a stable and lightweight construction of the telescopic lifting device.

In a further development of the invention, the lifting means is configured to move the sensor mounting platform from the transport means by 0 Meter to 5 Meter, preferably from 1 Meter to 4 Meter.

Thus, a high elevation of the sensor by the lifting means can be obtained due to stable and lightweight construction of the lifting device.

In a further development of the invention, the transport means has a distance between two of the at least two wheels of minimum 0.1 Meter, preferably minimum 0.25 Meter, and maximum 1 Meter.

Due to the construction, a portable and highly flexible transport device is obtained.

A ration between said lifting moving range and said wheel distance is beneficial between 5:1 and 5:0.1, preferably 5:0.25, especially for measuring devices under test bigger that a cube with at least one side of 1 meter, which equals the preferred maximum wheel distance between two wheels of the transport means.

In a further development of the invention, the spatial positioning device comprises four wheels, preferably six wheels, more preferably eight wheels, and preferably all axles are lying in one plane.

Virtually, common axles of wheel pairs can be thought through a respective pair of two wheels arranged on opposite sides of the positioning device.

It is beneficial, if two, three or four wheels are arranged on each side of the positioning device in one respective line.

Thus, a high stability of the spatial positioning device during movement/lifting is obtained, and the number of used wheels has a direct impact on the stability of the positioning device under operation, i.e. during repositioning.

In a further development of the invention, spatial positioning device comprises:
- four wheels, constituting two chain drives with respective track belts,
- preferably six wheels, constituting two chain drives with respective track belts,
- more preferably eight wheels, constituting two chain drives with respective track belts,

wherein the track belts are preferably made of polyurethane and comprise a V-shape form on the inner side of the respective track belt,
and preferably all axles are lying in one plane.

Thus, an even higher stability of the spatial positioning device during movement/lifting is obtained.

Virtually, common axles of wheel pairs can be thought through a respective pair of two wheels arranged on opposite sides of the positioning device.

It is beneficial, if two, three or four wheels are arranged On each side of the positioning device in one respective line to constitute the chain drives together with the respective track belt.

The combination of the chain drive, i.e. track belts, and the height of the allows an even higher horizontal accuracy for the positioning.

In a further development of the invention, the suspension means is mainly made of plastic, preferably polymer composites.

By this, the suspension can also made of an electrically non-conductive material, which reduces further the interference at electromagnetic measurements.

In a further development of the invention, the suspension means is made of a spring formed by an elastic element, which has a thickness of less than 10% of the width or length of the element.

By this, the suspension can be realized by 3D-printed or injection molded plastic parts.

In a further development of the invention, the spatial positioning device further comprises a control means, which is configured to control respective actuators comprised by the sensor mounting platform, the lifting means and the transport means.

The measurement setup of spatial positions required at a measurement campaign can be predefined and loaded into the spatial positioning device, communicated to the control means wirelessly or wired, and the control means can control respective actuator for performing movements or lifts of the sensor platform means, where the sensor is mounted.

In a further development of the invention, the spatial positioning device further comprises a remote controller, which is configured to control the control means and is connected to the control means wirelessly or wired, preferably by a glass fiber connection.

The measurement setup of spatial positions required at a measurement campaign can be transformed into control commands, communicated to the spatial positioning device, wirelessly or wired, and the commands can be received and executed by the control means in real time.

The objective of the invention is also solved by a mobile sensor system, comprising a spatial positioning device according to the invention, further comprising a device under test and a sensor mounted on the sensor mounting platform, preferably its the sensor means, a sensor for measuring electromagnetic emissions.

In a further development of the invention, the spatial positioning device is arranged on a horizontal plane with minor irregularities, on which the device under test is also located stationary, and on which plane the spatial positioning device can move around the device under test, and the spatial positioning device having the plane of its axles in parallel to the horizontal plane, controlled by the control means and the sensor is controlled by the control means.

It is beneficial to apply the spatial positioning device for a device under test with a geometry having a cube with at least one side with more than one meter side length.

All axles are arranged within one plane, which is parallel to the horizontal ground plane.

Thus, the constituted chain drive has one plane in direct contact to the ground plane.

The plane of the axles is of course only in one plane when the axles are in a default state of the spatial positioning device.

It is the purpose of the suspension means to compensate minor roughness or irregularities of the ground plane, on which the spatial positioning device is moved or temporarily positioned by the transport means.

The roughness or irregularities of the ground plane to be compensated is limited, for instance the half or a quarter or even less of the diameter of the wheels.

When the ground plan has a certain roughness or irregularity, which is compensated by the suspension means, it is obvious that in this state the axles are not aligned within one plane.

The invention is explained in the encompassed figured by an example. The figures show in:
- Fig. 1: an embodiment of the invention with an extended lifting device,

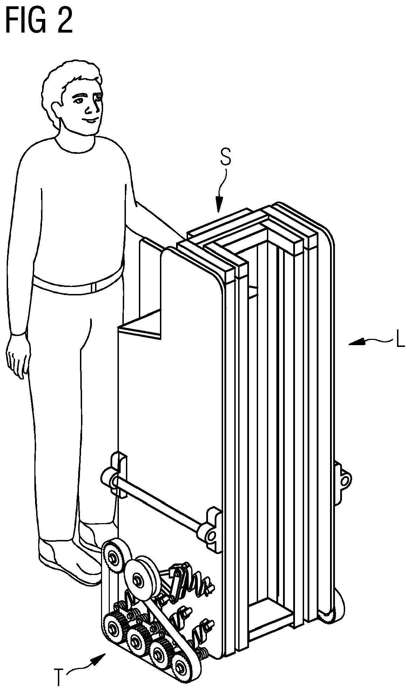

- Fig. 2: said embodiment of the invention with a lifting device draw together,
- Fig. 3: a partial section of said embodiment of the invention showing the transport device in detail,
- Fig. 4: a partial section in back view of said embodiment of the invention showing the transport device in detail with a control cabinet.

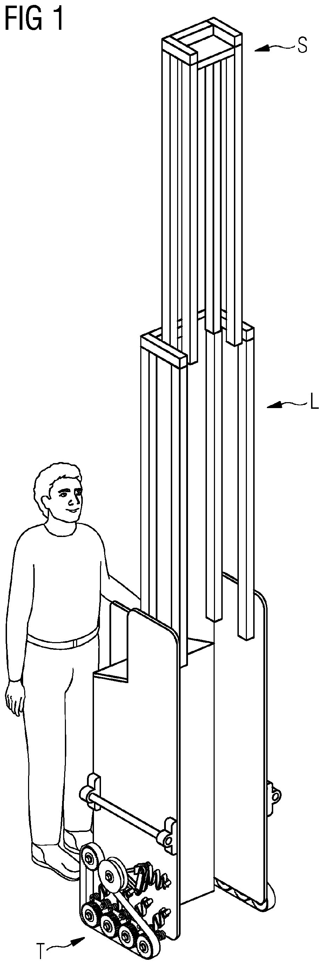

Fig. 1 - Fíg. 4 show an embodiment of the invention in different views and in configurations with an extended lifting device and with the lifting device draw together.

The shown embodiment of the invention shows an electromagnetic measurement setup for an energy transformer.

Obviously, the figures show only a principal overview of the device without details like a measurement sensor, a power supply, further data communication details like cables or a drive train etc.

The transformer manufacturing needs an EMF (Electro Magnetic Field) measurement validation mainly due to health concerns.

This validation needs EMF measurements in exact positions from the transformer both horizontally and vertically in multiple directions around the transformer.

Largest electric power transformers need measurement positions up to 4 m in height.

This measurement must be done in a faraday cage without conductive material near to the measurement because they alter the test results.

The figure shows a spatial positioning device, comprising a sensor mounting platform S to mount a sensor means, a lifting means L to lift the sensor means vertically, and a transport means T to move the lifting means L horizontally.

The sensor means itself is not shown in the figures, but only the sensor mounting platform, on which the sensor means is to be mounted.

The sensor means can be a radio receiver with an antenna or a S-parameter test equipment, and the sensor means can be powered by a battery to provide a power supply to the sensor means.

Moreover, the sensor means can capture sensor data using said receiver and transmit the captured sensor data by an optical fiber cable, which does not interfere to the measurement setup, to a data receiver of a control device located apart.

Alternatively, a free-space light-based communication like Li-Fi (derived from light fidelity), which is an optical wireless technology for data transmission and which works with the spectrum of light - more precisely with visible light or infrared radiation, can be used for the data transmission from the sensor to the data receiver of the control device.

The lifting means L is arranged between the sensor mounting Platform S and the transport means.

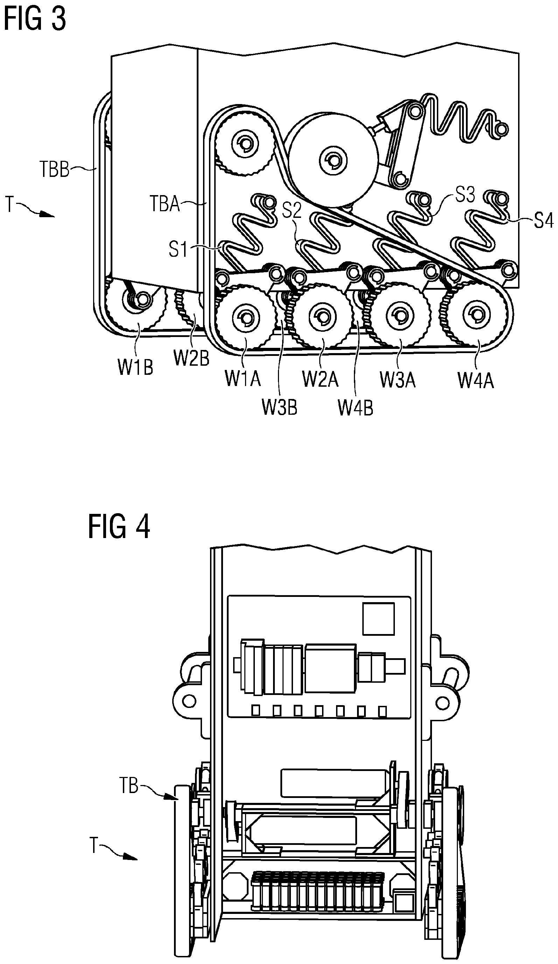

The transport means T comprises at least two wheels, shown in Fig. 3 is detail with references W1A-W4A, W1B-W4B with respective axles.

The wheels W1A-W4A, W1B-W4B have respective individual suspension means S1-S4.

The axles of the wheels are arranged in one plane in a predefined reference position, where all suspensions are in a default state on a flat surface.

The sensor mounting platform S, the lifting means L and the transport means T are mainly made of an electrically non-conductive material, in particular by at least of 90%, preferably at least of 95% by volume.

The lifting means L contains glass fiber composite material.

The lifting means L is in this example a cascade actuator, i.e. a lift construction including telescopic rails made of glass fiber composite and at least one lifting belt made of rubber with aramid tensile cords, which is configured to move the telescopic rails.

The lifting means L is configured to move vertically the sensor mounting platform S from the transport means T up to 4 Meter.

The transport means T has a distance between two of the at least two wheels W1A-W4A, W1B-W4B of ca. 0.12 Meter.

The spatial positioning device comprises eight wheels W1A-W4A, W1B-W4B, and all axles are lying in one plane.

The eight wheels W1A-W4A, W1B-W4B constitute two chain drives with respective track belts TBA, TBB.

The track belts TBA, TBB are made of polyurethane and comprise a V-shape form on the inner side of the respective track belt TBA, TBB and comprise further teeth (not shown in the figure).

The suspension means S1-S4 is mainly made of polymer composites to constitute an elastic plastic element.

The suspension means S1-S4 are made of a spring formed by an elastic plastic element, which has a thickness of less than 10% of the width or length of the element, which enables the production by a 3D printing process.

The spatial positioning device further comprises a control means, which is configured to control respective actuators comprised by the sensor mounting platform S, the lifting means L and the transport means T.

The spatial positioning device comprises further a remote controller, which is configured to control the control means and is connected to the control means wirelessly or wired, preferably by a glass fiber connection.

At a glance, a mobile sensor system is constituted, comprising the spatial positioning device, a device under test and a sensor mounted on the sensor mounting platform.

The sensor means is a sensor for measuring electromagnetic emissions or fields, like a radio receiver with an antenna.

The spatial positioning device is arranged on a horizontal ground plane, maybe containing minor irregularities, on which the device under test is also located stationary during the test or measurement.

On the ground plane the spatial positioning device can move around the device under test for performing the measurement campaign.

The ground plain is not shown in the figures, but it is clear that it is the ground of a shielded measurement cited, for instance an EMC lab (EMC = "electromagnetic compatibility").

The spatial positioning device has the plane of its axles in parallel to the horizontal plane, controlled by the control means and the sensor is controlled by the control means.

*Independent of the grammatical term usage, individuals with male, female or other gender identities are included within the term.*

### List of reference numerals:

- L: lifting module, lifting means
- S: sensor mounting platform
- S1-S4: spring
- T: transport module, transport means
- TBA, TBB: track belt, chain drive
- W1A-W4A, W1B-W4B: wheel

## Claims

1. Spatial positioning device, comprising:
- A sensor mounting platform (S) to mount a sensor means,
- A lifting means (L) to lift the sensor means vertically,
- A transport means (T) to move the lifting means (L) horizontally,
wherein the lifting means (L) is arranged between the sensor mounting platform (S) and the transport means (T),
and the transport means (T) comprises at least two wheels (W1A-W4A, W1B-W4B) with respective axles, which wheels (W1A-W4A, W1B-W4B) having an individual suspension means (S1-S4), and which axles are arranged in one plane,
and the sensor mounting platform, the lifting means (L) and the transport means (T) are mainly made of an electrically non-conductive material.

2. Spatial positioning device according to the preceding claim, wherein sensor mounting platform, the lifting means (L) and the transport means (T) are made of an electrically non-conductive material by at least of 90%, preferably at least of 95% of the volume of the spatial positioning device.

3. Spatial positioning device according to one of the preceding claims, wherein the lifting means (L) contains glass fiber composite.

4. Spatial positioning device according to one of the preceding claims, wherein the lifting means (L) is a cascade actuator, preferably including telescopic rails made of glass fiber composite and at least one lifting belt made of rubber or polyurethane, comprising aramid tensile cords or glass fiber tensile cords, which is arranged to move the telescopic rails, which is configured to move the telescopic rails.

5. Spatial positioning device according to one of the preceding claims, wherein the lifting means (L) is configured to move the sensor mounting platform (S) from the transport means (T) by 0 Meter to 5 Meter, preferably from 1 Meter to 4 Meter.

6. Spatial positioning device according to the preceding claim, wherein the transport means (T) has a distance between two of the at least two wheels (W1A-W4A, W1B-W4B) of minimum 0.1 Meter, preferably minimum 0.25 Meter, and maximum 1 Meter.

7. Spatial positioning device according to one of the preceding claims, wherein the spatial positioning device comprises four wheels (W1A-W4A, W1B-W4B), preferably six wheels (W1A-W4A, W1B-W4B), more preferably eight wheels (W1A-W4A, W1B-W4B), and preferably all axis are lying in one plane.

8. Spatial positioning device according to one of the preceding claims, comprising:
- four wheels (W1A-W4A, W1B-W4B), constituting two chain drives with respective track belts (TBA, TBB),
- preferably six wheels (W1A-W4A, W1B-W4B), constituting two chain drives with respective track belts (TBA, TBB),
- more preferably eight wheels (W1A-W4A, W1B-W4B), constituting two chain drives with respective track belts (TBA, TBB),
wherein the track belts (TBA, TBB) are preferably made of polyurethane and comprise a V-shape form on the inner side of the respective track belt (TBA, TBB),
and preferably all axles are lying in one plane.

9. Spatial positioning device according to one of the preceding claims, wherein the suspension means (S1-S4) is mainly made of plastic, preferably polymer composites.

10. Spatial positioning device according to one of the preceding claims, wherein the suspension means (S1-S4) is made of a spring formed by an elastic element, which has a thickness of less than 10% of the width or length of the element.

11. Spatial positioning device according to one of the preceding claims, further comprising a control means, which is configured to control respective actuators comprised by the sensor mounting platform, the lifting means (L) and the transport means (T).

12. Spatial positioning device according to the preceding claim, further comprising a remote controller, which is configured to control the control means and is connected to the control means wirelessly or wired, preferably by a glass fiber connection.

13. Mobile sensor system, comprising a spatial positioning device according to one of the preceding claims, further comprising a device under test and a sensor mounted on the sensor mounting platform, preferably is the sensor means a sensor for measuring electromagnetic emissions.

14. Mobile sensor system according to the preceding claim, wherein the spatial positioning device is arranged on a horizontal plane with minor irregularities, on which the device under test is also located stationary, and on which plane the spatial positioning device can move around the device under test, and the spatial positioning device having the plane of its axles in parallel to the horizontal plane, controlled by the control means and the sensor is controlled by the control means.
